# EUROPÄISCHE PATENTSCHRIFT

(11) **EP 1 714 533 B1**
(45) Veröffentlichungstag und Bekanntmachung des Hinweises auf die Patenterteilung: **30.05.2007**
(21) Anmeldenummer: 04802994.6
(22) Anmeldetag: 24.12.2004
(51) Int. Cl.: H05K 3/30

(54) **ELEKTRISCHE BAUGRUPPE MIT EINEM ELEKTRISCH LEITFÄHIGEN KONTAKTSTIFT ZUM EINPRESSEN IN EINE ÖFFNUNG EINER LEITERPLATTE**
ELECTRIC SUB-ASSEMBLY COMPRISING AN ELECTRICALLY CONDUCTIVE CONTACT PIN FOR PRESSING INTO AN OPENING OF A PRINTED CIRCUIT BOARD
COMPOSANT ELECTRIQUE COMPRENANT UNE FICHE DE CONTACT ELECTROCONDUCTRICE ET DESTINE A ETRE ENFONCE DANS UN ORIFICE D'UNE CARTE DE CIRCUITS IMPRIMES

(30) Priorität: 11.02.2004 DE 102004006533
(43) Veröffentlichungstag der Anmeldung: 25.10.2006
(73) Patentinhaber: Conti Temic microelectronic GmbH, 90411 Nürnberg (DE)
(72) Erfinder: THIEL, Wolfgang, 85095 Denkendorf (DE); GRAUBMANN, Jörg, 85072 Eichstätt (DE); RIESE, Dirk, Oliver, Dr., 90478 Nürnberg (DE)
(86) Internationale Anmeldenummer: PCT/DE2004/002814
(87) Internationale Veröffentlichungsnummer: WO 2005/079127

(56) Entgegenhaltungen:
- DE-A1- 3 801 352
- DE-C1- 4 406 200
- US-A- 4 236 776
- US-A- 4 475 780
- US-A- 5 374 204
- US-A- 6 080 012
- US-A1- 2003 102 357

## Beschreibung

Die Erfindung betrifft eine elektrische Baugruppe mit einem elektrisch leitfähigen Kontaktstift zum Einpressen in eine Öffnung einer Leiterplatte gemäß dem Oberbegriff von Anspruch 1. Eine solche Baugruppe ist aus DE-A-5 374 204 bekannt.

Derartige Einpresskontaktstifte werden massiv aus einem Vollstück oder elastisch durch Ausgestaltung von Federöffnungen ausgebildet. Die Öffnung der Leiterplatte ist dabei metallisiert und hat dabei vorgegebene Abmaße, also bei den in der Regel vorgesehenen runden Öffnungen einen Durchmesser. Der Kontaktstift weist demgegenüber zumindest in einem Teilbereich zum Ausbilden einer Pressverbindung ein definiertes Übermaß gegenüber den Abmaßen der Öffnung auf, was eine Presspassung definiert. In der Regel ist zudem die einführbare Länge des Kontaktstifts größer ist als die Tiefe der Öffnung, so daß der Kontaktstift im eingepressten Zustand durch die Leiterplatte hindurch in Einführrichtung übersteht.

Insbesondere bei massiven Kontaktstiften treten an Leiterplatten, insbesondere an Leiterplatten aus CEM- oder FR4-Materialien, Verformungen im Randbereich der Öffnungen aufgrund der Kräfte beim Einpressen auf. Insbesondere bei nicht durchkontaktierten Öffnungen besteht dann die Gefahr, dass mit die auf der in Einführrichtung des Kontaktstifts entgegengesetzten Seite liegende Leiterbahn nicht kontaktiert wird. Insbesondere können auch Bereiche des dielektrischen Grundmaterials der Leiterplatte beim Einpressen in Einpressrichtung zwischen den Kontaktstift und die Leiterbahn der Leiterplatte geschoben werden. Da das dielektrische Grundmaterial selbst bei einem Lötprozess nicht benetzungsfähig ist, kann eine Kontaktierung dann nicht aufgebaut werden.

Aufgabe der Erfindung ist es, eine elektrische Baugruppe anzugeben, die diese Probleme umgeht. Diese Aufgabe wird durch die Merkmale des Anspruchs 1 gelöst. Vorteilhafte Weiterbildungen sind den Unteransprüchen zu entnehmen.

Die Erfindung wird nachfolgend anhand von Figuren und Ausführungsbeispielen näher erläutert. Es zeigen:
- Fig. 1: Baugruppe mit einem erfindungsgemäßen Kontaktstift
- Fig. 2: Kontaktstift und Leiterplatte vor dem Einpressen

Zur Vermeidung der Verformungen und damit ggfs. einhergehenden elektrischen Kontaktprobleme weist der Kontaktstift nur über eine erste Teillänge I1.1 ein Übermaß gegenüber den Abmaßen der Öffnung 2 auf, d.h. der gegenüber dem Durchmesser D2 der Öffnung größere Durchmesser D1.1 erstreckt sich nur über einen Teil des Kontaktstifts und es ist in Einführrichtung voranliegend eine zweite Teillänge (11.2) mit einem Untermaß (D 1.2<DZ) vorgesehen, welches kleiner ist als das Abmaß der Öffnung (D2).

Die erste Teillänge I1. 1 ist dabei kleiner als die Tiefe 12 der Öffnung 2 der Leiterplatte, so daß nach dem Einführen zumindest ein Teil des zweiten Teilbereichs 11.2 in der Öffnung verbleibt. Dadurch wird sichergestellt, daß es beim Einpressen auch bei massivem Kontaktstiften zu keiner oder einer deutlich geringeren Verformung der Leiterplatte auf der in Einführrichtung gegenüberliegenden Seite kommt. Nach dem Einpressen verbleibt so zwischen dem Kontaktstift 1 und der Öffnung 5 im unteren Randbereich ein Zwischenraum 7, der bei sinnfälliger Dimensionierung ausreichend ist, um ein Aufsteigen von Lot 8 in diesen Zwischenraum 7 zu ermöglichen.

Der Rand der ersten Teillänge I1.1 des Kontaktstifts 1 mit dem Übermaß D1 kontaktiert nach dem Einpressen den Rand 3.2 der Kontaktzone 3, welcher den Abmaßen der Öffnung 2 entspricht. Dabei kommt es vorzugsweise zu einer Kaltverschweißung zwischen dem Kontaktstift 1 und der Kontaktzone 3 an deren Rand 3.2 und entsteht auf der Oberseite der Leiterplatte eine gasdichte lötfreie Einpressverbindung zwischen dem Kontaktstift 1 und der Kontaktzone 3.

Die einführbare Länge I1 des Kontaktstifts 1 wird durch den aus dem Kontaktstift ausgeformten Anschlag 1.3 begrenzt, wobei dieser vorzugsweise zur besseren Kraftverteilung zumindest an zwei Seiten axial symmetrisch oder umlaufend ausgebildet ist.

Der zweite Teilbereich I1.2 weist in der gezeigten Ausgestaltung einen Übergangsbereich zum ersten Teilbereich I1.1 auf, in welchem eine stetige Verjüngung erfolgt. Dadurch können ein Verkanten beim Einführen verhindert und eine relative konzentrische Ausrichtung des Kontaktstifts 1 zur Öffnung 2 ermöglicht werden.

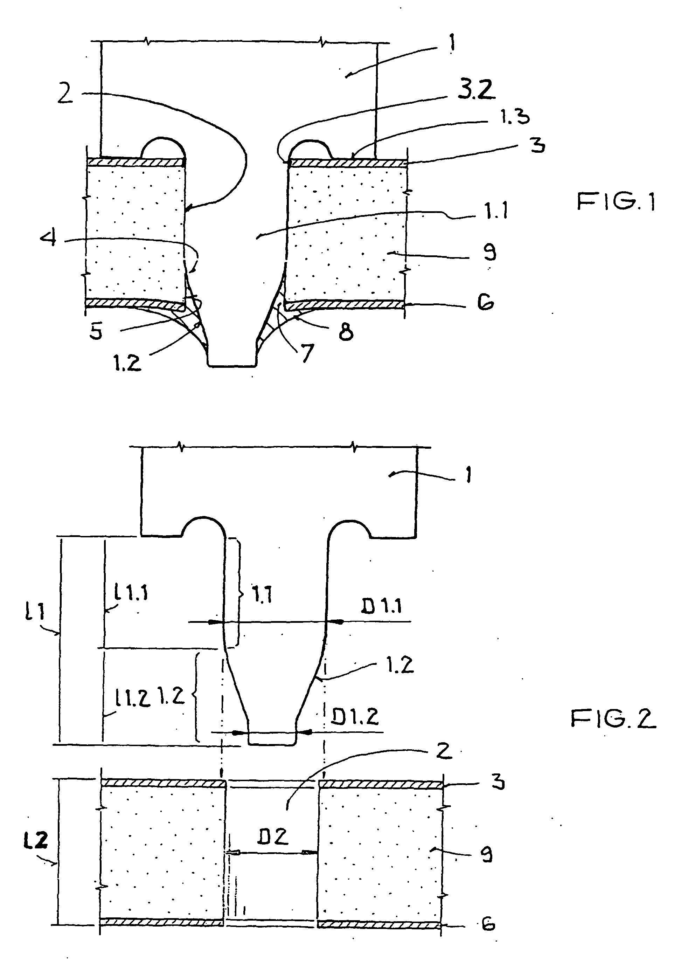

Ein derartiger Kontaktstift wird vorzugsweise durch Schwall-Löten auf der der Einführrichtung des Kontaktstifts entgegengesetzten Seite mit der Leiterplatte verbunden. Der besondere Vorteil dieses Kontaktstifts zeigt sich bei der Betrachtung einer entsprechenden Verbindung, welche in Fig. 1 skizziert ist. Dort ist deutlich die geringere Verformung im unteren Randbereich der Öffnung 2 der Leiterplatte und die Ausbildung einer guten Lötverbindung auf der Unterseite durch Einfließen des Lots während des Schwalllötens zu erkennen, wobei gerade kaum dielektrisches Leiterplattenplattenmaterial 9 in diesem Randbereich verformt, zumindest nicht bis in den Bereich zwischen Kontaktstift und Leiterbahn 6 gebracht wird, so dass auch keine Benutzungsprobleme auftreten.

Ein derartiger Kontaktstift kann für die Anbindung elektrischer Bauelemente einer elektrischen Baugruppe an einer Leiterplatte genutzt werden, wobei zumindest ein Bauelement entsprechende Kontaktstifte 1 aufweist und die Kontaktstifte 1 auf der in Einführrichtung entgegengesetzten Seite der Leiterplatte durch Schwall-Löten mit einer Leiterbahn 6 der Leiterplatte 9 elektrisch verbunden sind.

Zudem eignet sich ein derartiger Kontaktstift für die Ausbildung einer Verbindung zwischen elektrischen Leiterbahnen 3,6 auf der Ober- und Unterseite einer Leiterplatte, indem der Kontaktstift 1 in eine Öffnung 2 von Kontaktzonen der Leiterbahnen 3,6 auf der Ober- und Unterseite der Leiterplatte 9 eingepresst ist. Der Anschlag 1.3 des Kontaktstifts (1) berührt dabei auf der in Einführrichtung liegenden Seite die dort befindliche Kontaktzone der Leiterbahn 3, während der Kontaktstift 1 auf der in Einführrichtung entgegengesetzten Seite durch Schwall-Löten mit der dort liegenden Kontaktzone der Leiterbahn 6 elektrisch verbunden ist.

Derartige elektrische Baugruppen können mit einer Leiterplatte 9 aus preiswertem Material, insbesondere CEM 1, CEM3 oder FR4 aufgebaut sein, die bisher für Baugruppen mit Einpreß-Kontaktstiften, insbesondere massiven Kontaktstiften ungeeignet waren. Die Öffnung 2 in der Leiterplatte 9 braucht dabei nicht metallisiert zu sein und kann in der Leiterplatte 9 gestanzt werden.

Gerade für diese preiswerten Leiterplatten können durch die vorgeschlagenen Kontaktstifte in Verbindung mit dem Schwalllötprozeß auf der Unterseite deutliche Kosteneinsparungen erzielt werden.

## Patentansprüche

1. Elektrische Baugruppe bestehend aus einer nicht-durchkontaktierten Leiterplatte (2) mit elektrischen Leiterbahnen (3,6) auf der Ober- und Unterseite, **wobei** eine elektrische Verbindung zwischen Leiterbahnen (3,6) auf der Ober- und Unterseite durch zumindest einen elektrisch leitfähigen Kontaktstift (1) erfolgt, wobei
a) die Leiterplatte zumindest eine Öffnung (2) aufweist,
b) die Öffnung (2) der Leiterplatte vorgegebene Abmaße (D2) hat und der Kontaktstift (1) über eine erste Teillänge (I1.1) zum Ausbilden einer Pressverbindung **Abmaße (D1.1) größer als die Abmaße** (D2) der Öffnung hat und
c) in Einführrichtung voranliegend eine zweite Teillänge (I1.2) **mit Abmaßen (D1.2) aufweist, welches kleiner sind als das Abmaß** der Öffnung (D2),
d) wobei die erste Teillänge (I1.1) kleiner als die Tiefe (I2) der Öffnung (2) der Leiterplatte ist, so daß nach dem Einführen zumindest ein Teil des zweiten Teilbereichs (11.2) in der Öffnung verbleibt,
e) die einführbare Länge (11) des Kontaktstifts (1) größer ist als die Tiefe (12) der Öffnung (2), so daß der Kontaktstift (1) im eingepressten Zustand durch die Leiterplatte (2) hindurch in Einführrichtung übersteht,
f) um die Öffnung (2) auf der Ober- und Unterseite der Leiterplatte (9) jeweils Kontaktzonen vorgesehen sind (3,6), welche einen den Abmaßen (D2) der Öffnung (2) entsprechenden Rand bilden, so daß der Kontaktstift (1) im eingepressten Zustand auf der in Einführrichtung liegenden Seite die dort befindliche Kontaktzone (3) der Leiterbahn kontaktiert, **dadurch gekennzeichnet, dass**
g) **die Öffnung (2) nicht-metallisiert** und der Kontaktstift (1) auf der in Einführrichtung entgegengesetzten Seite durch Schwall-Löten mit der dort liegenden Kontaktzone (6) der Leiterbahn elektrisch verbunden ist.

2. Elektrische Baugruppe nach Anspruch 1, **dadurch gekennzeichnet, daß** der zweite Teilbereich (I1.2) des Kontaktstifts einen Übergangsbereich zum ersten Teilbereich (I1.1) aufweist, in welchem eine stetige Verjüngung erfolgt.

3. Elektrische Baugruppe nach Anspruch 1 oder 2, **dadurch gekennzeichnet, daß** der Kontaktstift (1) massiv ausgeführt ist.

4. Elektrische Baugruppe nach einem der vorangehenden Ansprüche, **dadurch gekennzeichnet, daß** eine Leiterplatte (9) aus CEM- oder FR4-Material verwendet wird.

5. Elektrische Baugruppe nach einem der vorangehenden Ansprüche, **dadurch gekennzeichnet, daß** ein Anschlag (1.3) vorgesehen ist, welcher die einführbare Länge (I1) des Kontaktstifts (1) begrenzt.

6. Elektrische Baugruppe nach einem der vorangehenden Ansprüche; **dadurch gekennzeichnet, daß** beim Einpressen des Kontaktstifts (1) auf der in Einführrichtung liegenden Seite der Rand der dort befindlichen Kontaktzone (3) mit dem Kontaktstift (1) kaltverschweißt wird und auf der Oberseite der Leiterplatte eine gasdichte lötfreie Einpressverbindung zwischen dem Kontaktstift (1) und der Kontaktzone (3) entsteht.

7. Elektrische Baugruppe einem der vorangehenden Ansprüche, **dadurch gekennzeichnet, daß** die Öffnung (2) in der Leiterplatte (9) gestanzt ist.

## Claims

1. An electric sub-assembly consisting of a non-contacted printed circuit board (2) with electric conductor tracks (3, 6) on the upper and lower faces, whereby an electrical connection is made between conductor tracks (3, 6) on the upper and lower faces by at least one electrically conductive contact pin (1), whereby
a) the printed circuit board has at least one hole (2),
b) the hole (2) of the printed circuit board has predetermined dimensions (D2) and the contact pin (1) has dimensions (D1.1) greater than the dimensions (D2) of the hole over a first partial length (I1.1) to form a press connection, and
c) in the introduction direction has a second partial length (11.2) with dimensions (D1.2) smaller than the dimension of the hole (D2),
d) whereby the first partial length (11.1) is less than the depth (12) of the hole (2) of the printed circuit board, so that at least one part of the second sub-section (I1. 2) remains in the hole once it is introduced,
e) the introducible length (11) of the contact pin (1) is greater than the depth (12) of the hole (2), so that the contact pin (1) projects through the printed circuit board (3, 6) in the introduction direction once the pin has been pressed in,
f) in each case contact zones (3, 6) are provided around the hole (2) on the upper and lower faces of the printed circuit board (9), which form an edge corresponding to the dimensions (D2) of the hole (2), so that in the pressed-in state on the side in the introduction direction the contact pin (1) contacts the contact zone (3) of the conductor track located on said side, **characterised in that**
g) the hole (2) is non-metallized and on the side opposite to the introduction direction the contact pin (1) is connected electrically by flow-soldering to the contact zone (6) of the conductor track located on said side.

2. An electric sub-assembly according to Claim 1, **characterised in that** the second sub-section (11. 2) of the contact pin has a transition region to the first sub-section (I1.1), in which constant tapering takes place.

3. An electric sub-assembly according to Claim 1 or 2, **characterised in that** the contact pin (1) is designed solid.

4. An electric sub-assembly according to any one of the preceding claims, **characterised in that** a printed circuit board (9) made of CEM or FR4 material is used.

5. An electric sub-assembly according to any one of the preceding claims, **characterised in that** a stop (1.3) is provided, which delimits the introducible length (I1) of the contact pin (1).

6. An electric sub-assembly according to any one of the preceding claims, **characterised in that** once the contact pin (1) is pressed in the edge of the contact zone (3) located on the side lying in the introduction direction is cold-soldered to the contact pin (1) and on the upper face of the printed circuit board a gas-tight solder-free press-in connection is established between the contact pin (1) and the contact zone (3).

7. An electric sub-assembly according to any one of the preceding claims, **characterised in that** the hole (2) in the printed circuit board (9) is punched.

## Revendications

1. Module électrique, composé d'une carte imprimée (2) sans trous métallisés, avec des pistes conductrices (3, 6) électriques sur le côté supérieur et le côté inférieur, une connexion électrique intervenant entre des pistes conductrices (3, 6) sur le côté supérieur et le côté inférieur par au moins une broche de contact (1) électriquement conductrice,
a) la carte imprimée présentant au moins une ouverture (2),
b) l'ouverture (2) de la carte imprimée ayant des dimensions (D2) prédéfinies, et la broche de contact (1) ayant, sur une première longueur partielle (11.1), pour la formation d'une connexion serrée, des **dimensions (D1.1) plus grandes** que les dimensions (D2) de l'ouverture, et
c) présentant, placée avant dans le sens d'introduction, une deuxième longueur partielle (11.2) avec des dimensions (D1.2) qui sont plus petites que la dimension de l'ouverture (D2),
d) la première longueur partielle (11.1) étant plus petite que la profondeur (12) de l'ouverture (2) de la carte imprimée, de sorte que, après l'introduction, au moins une partie de la deuxième longueur partielle (11.2) demeure dans l'ouverture,
e) la longueur (11), pouvant être introduite, de la broche de contact (1) étant plus grande que la profondeur (12) de l'ouverture (2), de sorte que la broche de contact (1), dans l'état pressé, fait saillie à travers la carte imprimée (3,6) dans le sens d'introduction,
f) des zones de contact étant respectivement prévues (3, 6) autour de l'ouverture (2) sur le côté supérieur et le côté inférieur de la carte imprimée (9), ces zones formant un bord correspondant aux dimensions (D2) de l'ouverture (2), de sorte que la broche de contact (1), dans l'état pressé, sur le côté situé dans le sens d'introduction, est mise en contact avec la zone de contact qui s'y trouve, **caractérisé en ce que**
g) l'ouverture (2) est non métallisée, et la broche de contact (1) est, par brasage tendre à la vague, connectée électriquement à la zone de contact (6) de la piste conductrice qui s'y trouve, sur le côté opposé au sens d'introduction.

2. Module électrique selon la revendication 1, **caractérisé en ce que** la deuxième longueur partielle (11.2) de la broche de contact présente une zone de transition par rapport à la première longueur partielle (11.1), zone dans laquelle intervient un rétrécissement constant de la section.

3. Module électrique selon la revendication 1 ou 2, **caractérisé en ce que** la broche de contact (1) est réalisée de façon massive.

4. Module électrique selon une des revendications précédentes, **caractérisé en ce qu'**une carte imprimée (9) en matériau CEM ou FR4 est utilisée.

5. Module électrique selon une des revendications précédentes, **caractérisé en ce qu'**il est prévu une butée (1.3) qui limite la longueur (11) pouvant être introduite de la broche de contact (1).

6. Module électrique selon une des revendications précédentes, **caractérisé en ce que**, lors du pressage de la broche de contact (1) sur le côté situé dans le sens d'introduction, le bord de la zone de contact (3) qui s'y trouve est soudé à froid avec la broche de contact (1), et qu'il apparaît, sur le côté supérieur de la carte imprimée, une connexion pressée, exempte de brasure, étanche aux gaz, entre la broche de contact (1) et la zone de contact (3).

7. Module électrique selon une des revendications précédentes, **caractérisé en ce que** l'ouverture (2) dans la carte imprimée (9) est poinçonnée.
